# EUROPEAN PATENT APPLICATION

(11) **EP 3 002 694 A1**
(43) Date of publication of application: **06.04.2016**
(21) Application number: 14186980.0
(22) Date of filing: 30.09.2014
(51) Int. Cl.: G06F 17/50, G06T 17/20

(54) **Method and computing apparatus for simplifying a geometrical model**

(71) Applicant: FUJITSU LIMITED, Kawasaki-shi, Kanagawa 211-8588 (JP)
(72) Inventor: KUBOTA, Tetsuyuki, Acton, Greater London W3 0NX (GB); CHOW, Peter, Gillingham, Kent ME7 3AH (GB); GEORGESCU, Serban, London, Greater London W5 3JY (GB); SAKAIRI, Makoto, Kawasaki-shi, Kanagawa 211-8588 (JP)
(74) Representative: Wilding, Frances Ward

(57) **Abstract**

A method of simplifying a geometrical model, wherein the geometrical model includes a pattern of perforations in a perforated component and an edge pattern where the pattern of perforations finishes at a component border as one or more incomplete perforations, the method comprising: detecting the pattern of perforations in the perforated component; detecting one or more edge features of the edge pattern; comparing a perforation from the pattern of perforations with an edge feature; using the comparison to detect an incomplete perforation of the edge pattern; and removing the detected pattern of perforations and the detected incomplete perforation of the edge pattern from the geometrical model.

## Description

The present invention relates to computer-aided design and engineering (CAD and CAE). In particular it relates to potential adaptation of a model created of an object in a computer environment, in order to render that model more suitable for analysis.

Invention embodiments relate specifically to detection and simplification of patterned holes, and are useful in model modification for simulation (e.g. for structural analysis, or for maintaining thermal fluid dynamics). The target application may be 3-dimensional simulation software which is used in the development of manufacturing products.

This modification process is most commonly found in design and manufacturing processes. For example, an engineer may design a product prototype in the form of a component or complex part using a model in a CAD (computer-aided design) package such as AUTO CAD or Pro/ENGINEER and then wish to test the model for suitability of use. Such analysis of the virtual prototype/model may be required for specification requirements such as durability, health and safety demands and manufacturability. The design engineer may for instance wish to analyse the model in simulations to determine heat resistance, propagation of electromagnetic or other fields or stress-strain properties. This simulation process can refine product design without entailing the cost of actual manufacture and physical test. However, it is often necessary to modify the model so that it is simplified and can be more easily analysed.

Recently, 3-dimensional (3-D) numerical simulation technologies (such as structure analysis or computational fluid dynamics (CFD)) have been generalized to help design and develop industrial products. Use of such techniques is associated with the growth of simulation technologies and computational power. When a 3-D simulation model is prepared, geometry data may be provided from 3D-CAD data. However, geometry data in 3D-CAD is generally too complex to use for 3-dimensional numerical simulation without modification. Therefore, geometry data in 3D-CAD is usually simplified for the reduction of computational scale. Simplification in CAD-to-CAE model preparation (CCMP) significantly reduces the model size (in terms of electronic storage) and prepares the model for various classes of analysis. Models usually require preparation in form of modification (sometimes known as defeaturing) to make them suitable for analysis/simulation. Until recently the CCMP stage has been labour intensive and largely a manual process. With the development of computer-aided tools that automatically detect and process features, efficiency has significantly improved.

The subsequent step in model set up after geometry simplification/modification is mesh generation. Automatic and fast mesh generation is available for both structured (finite difference) and unstructured (finite element) meshes. Usually, much simpler meshes can be used for simplified models

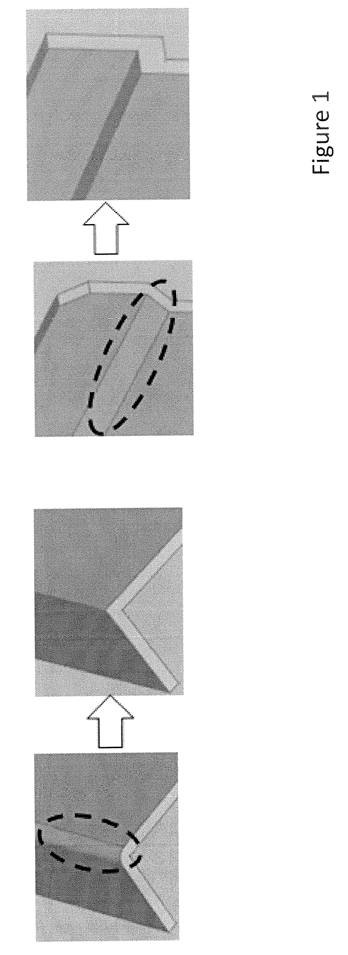

A first process in geometry data modification may be feature detection. Figure 1 shows two examples of modification. In this first process, blend and chamfer faces are detected, and then these faces are deleted (and replaced with faces that give a simpler profile).

A further modification process may relate to parts with patterns of perforation (regular arrays of through holes). A porous medium, such as a perforated sheet or other product which requires cooling may for example be used at a inlet or outlet in a product model for many ICT (information and communication technology) products such as for a server, laptop PC or storage system. When the porous medium is simplified, through-holes (referred to herein simply as holes) are detected.

The present invention relates specifically to perforations in geometric models. Perforated sheets and other perforated parts are commonly used in electronic products for protective covering and at the same time to allow airflow in and out of the device, usually for cooling purposes. Such parts are especially important in computer devices, where heat management is critical to product efficiency and operation. Therefore, product designers and engineers employ thermal airflow analysis to address the heat management issue. Another use of perforating may be in architectural models. Furthermore, perforations can be decorative features.

Running thermal airflow analysis or simulation is part of the computer-aided engineering (CAE) design and development process for ICT products. Using perforated part geometry without modification requires fine meshes and complex setting of flowrate conditions for each of the perforated holes next to the external boundaries defining the domain perimeter. Fine meshes lead to high computing resource demand and long analysis time. Moreover, setting conditions for individual perforated holes is extremely inefficient.

In thermal airflow and other analysis, one advantageous practice is therefore to treat the perforated region as a single porous region, with porosity based on an aperture ratio of perforations to area/volume of the part. This greatly simplifies the geometry (from perforated to non-perforated) and minimises the required boundary and/or internal condition setting. The change to a porous equivalent usually has no significant impact on solution accuracy and is very efficient. PCT/EP2011/057061, which is incorporated herein by reference, discloses a method for identifying a group of perforations and preferably converting the perforated region into a single porous region.

Generally, a porous medium can include not only holes but also an edge pattern. This can provide a border (or part of a border or border polyline) at the edge of the component. The border may be formed by the outside edge loop edge of a perforated component. A notional overall straight edge may 'cut across' the perforations, leaving a pattern of one or more incomplete perforations at the extremity of a pattern of perforations. However, it should be noted that the term "edge" is used herein in the usual CAD sense to refer to a single edge line (whether straight or curved) between two vertices, rather than in the general sense of an overall edge loop of a part, which is referred to herein as a "border".

The perforations are incomplete in that they form a through-hole, which does not have the full cross-section of a perforation, because it is cut across by the notional straight edge.

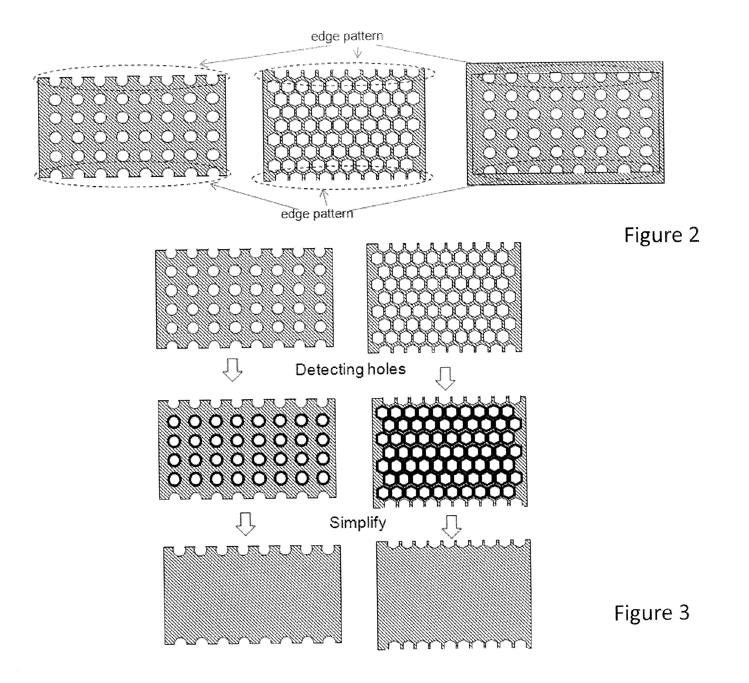

Figure 2 shows three examples of edge patterns. Each edge pattern shown here includes individual edge features which interrupt a notional straight edge line to form a repeating pattern. An example of the simplest edge pattern might be a single edge pattern. In the left-hand and central examples, the edge pattern is at the outer extremity (border) of a component, forming incomplete perforations which are open at one side (not completely bounded within the porous medium). These may not be detected by the PCT/EP2011/057061 prior art. In contrast, in the right-hand example, the upper most and lower most rows of perforation can be detected in this prior art as two groups of full perforations having a different geometry from the central full perforations.

Hence, when the porous medium model is simplified in th prior art, although holes are detected, patterns forming incomplete perforations on the edges are not detected. This applies not just to PCT/EP2011/057061 but also to removal of perforations using general software such as "CAD Doctor" and "CADfix". The effect is that only holes are deleted from the porous medium model; edge patterns forming incomplete perforations are not deleted. Figure 3 shows the results of such simplification, which leaves an edge pattern and gives a higher complexity of model geometry and hence leads to a more computationally intense simulation. Also, if an aperture ratio (aperture area/total area) is derived, an accurate result is not provided, due to use of this prior art simplification. Hence, when a porous medium model is simplified, the inventors have concluded that it is necessary to detect not only holes but also edge patterns.

It is desirable to detect and remove perforation patterns in porous medium, including not only holes but also edge patterns forming incomplete perforations.

Embodiments of a first aspect of the invention provide a method of simplifying a geometrical model, wherein the geometrical model includes a pattern of perforations in a perforated component and an edge pattern where the pattern of perforations finishes at a component border (of the performed component) as one or more incomplete perforations, the method comprising: detecting the pattern of perforations in the perforated component; detecting one or more edge features of the edge pattern; comparing a perforation from the pattern of perforations with an edge feature; using the comparison to detect an incomplete perforation of the edge pattern; and removing the detected pattern of perforations and the detected incomplete perforation of the edge pattern from the geometrical model.

According to this embodiment, not only is a pattern of perforation detected, but one or more edge features of an edge pattern are detected. A match between a perforation and an edge feature indicates that the edge feature is part of the pattern of perforations and forms an incomplete perforation (such as a recess in the model border effectively forming a through-hole. The recess might otherwise be the same size and shape as the perforation but is open at one side).

The inventors have come to the realisation that an edge pattern may be detected by simple comparison with a perforation to allow removal of the edge feature and simplification of the simulation of the perforated part. If both perforations and edge patterns are detected, the result of the simplification is suitable for modelling and accuracy of any derived aperture ratio is improved with respect to the prior art.

The one or more edge features may be detected by any suitable method. In one alternative, the one or more edge features are detected by finding any outside edge of the component which does not coincide with a rectangular boundary box fitted to the border (or outside edge loop) of the perforated component. Hence a simple rectangular boundary box may be used in some cases to detect edge features.

In another alternative suitable for more complex component shapes, the one or more edge features are detected by finding an individual outside edge of the component which is bounded by two vertices having outside angles of more than 180°. This is a slightly more widely applicable method, suitable for edge features forming recesses on any straight component border. The vertices having an outside angles of more than 180° effectively include any vertices which introduce an edge pattern or recess into the otherwise straight border.

In either case, in order to compare the edge feature with the perforation from the pattern of perforations, the remaining border may be removed. In the case of the boundary box alternative, the border may be removed where it coincides with the boundary box to leave a remaining pattern of one or more edge features. In the second case with vertices of more than 180°, the edge between two vertices with angles of more than 180° may be extended to form a boundary line along the perforated part (for example along the whole of the perforated part) and for the purposes of the comparison any border sections which overlap with the boundary line may be removed, leaving a remaining pattern of one or more edge features. Either of the two alternative edge feature detection methods may be selected automatically, for example according to the component shape, or by user input.

The method of invention embodiments is suitable for use if a single edge feature is present or if there is a plurality of edge features. In one arrangement, if there is more than one edge feature then a single edge feature of the remaining pattern (at a time) is selected for comparison. In any case, the comparison to detect an incomplete perforation may be carried out individually for each edge feature.

The edge feature comparison differs according to whether the edge feature comprises a plurality of edges or whether the edge feature is a single curve. Hence according to invention embodiments it may be determined that the edge feature comprises either plural edges or a single curved edge.

The comparison may include a geometrical comparison of the edge feature with the perforation. Thus the one or more edges making up the edge feature may be compared to the one or more edges of the perforation. An incomplete perforation may be detected if there is a match between the compared edges. The match may be in terms of geometrical features. For example if the edge feature is formed of plural edges, the method may find one edge of the edge feature with the same length, line type and angle as one edge of the perforation. In this context, line type may refer to curved and straight lines such as those used in boundary representation (b-rep) CAD models or any other line-type categorisation. The perforation and the edge feature may then be overlapped based on this edge.

Preferably each further edge of the edge feature is then matched for example sequentially, against an edge of the perforation. If no match is found for any one of the edges, the matching process is terminated. This lack of match indicates that there is no incomplete perforation. An incomplete perforation is detected if all the edges of the edge feature then overlap with the perforation. Since the perforation is incomplete, some edges of the perforation will continue beyond the corresponding edge of the edge feature.

As for the first edge, further edges are each matched by finding an edge of the perforation which has the same line type and angle. However the corresponding edge of the perforation has a length at least as long as the length of the further edge in the edge frame because it may extend beyond the further edge, as explained above.

A different procedure may be followed when an edge feature is formed of a single edge feature curve. This process applies, for example, for circular cross-section, ellipse cross-section, and spline cross section perforations and other continuous single curve shapes, for example as defined by mathematical functions. In this case, the method finds the central point around which the edge feature curve extends and the central point of the perforation and overlaps these points. An incomplete perforation may be detected if all of the curved edge of the edge feature then overlaps with the curved edge of the perforation. Evidently, the curved edge of the perforation will continue where the curved edge of the edge feature is cut off.

The pattern of perforations may be detected in any suitable way. In one embodiment, detecting the pattern of perforations includes detecting holes in a component, detecting distances between adjacent holes, and counting the number of identical holes which are spaced apart by an identical distance. Preferably a threshold is applied to the count, above which the detected holes are defined as a pattern of perforations and the component is defined as a perforated component.

Such a threshold may be applied because if there are only very few perforations, it may not be worthwhile to process them as a pattern. The lowest possible value of the threshold is 3. The user may input the value using a GUI.

Alternatively, a potential group of perforations (or through holes) may be automatically identified using prior art methodology from PCT/EP2011/057061, by providing a separate bounding box surrounding each through hole in a set of through holes; calculating the volume of each separate bounding box; increasing the size of each separate bounding box by an offset factor which adjusts the highest and lowest extent of the bounding boxes equally and oppositely in at least one of the mutually perpendicular x, y and z directions, so that at least two of said separate bounding boxes overlap; creating a united set of all the bounding boxes, whereby overlapping separate bounding boxes become a single combined bounding box; reducing the size of each bounding box in the united set by the offset factor; and extracting from the united set the one or more individual bodies formed by the one or more reduced-size bounding boxes, each individual body potentially representing a group of perforations; In this case, the removal of perforations (through holes) may include replacing one or more portions of the geometrical model corresponding to the one or more individual bodies with one or more porous replacement portions.

The edge features of the patterned edge may be detected before, after or in parallel with detection of the pattern of perforations in the perforated part. Clearly however the comparison of the two takes place after the detection processes. Removal of the detected pattern of perforations and the detected incomplete perforation can take place sequentially in either order or in parallel or together so that the pattern and incomplete perforations are grouped together and removed.

For some analyses, it may be satisfactory simply to remove the detected pattern of perforations and the detected incomplete perforations. However, for other applications, the solid portion of the component remaining is given a porosity value to replicate the effect of the perforations. For example, the solid portion of the component replacing the detected pattern of perforations and the detected incomplete perforations may have a porosity value corresponding to the porosity effect of the perforations and the incomplete perforations. This porosity value may be based on the ratio between the cross-sectional area of the pattern of perforations and incomplete perforations and an area of the surface of the perforated component through which they pass. Alternatively, a similar calculation may be made by volume. In this case the porosity value may be based on the ratio between the combined volume of the pattern of perforations and incomplete perforations and the volume of the patterned component. According to a further embodiment of the invention, which may be freely combined with the other aspects, invention embodiments provide a method of simplifying a geometrical model and of simulating its properties including carrying out the method of any of the preceding statements and subsequently executing a numerical simulation on the resultant simplified model.

According to a second aspect of the invention there is provided a computer program which when executed on a computing apparatus carries out the method of any of the preceding statements or any combination of the preceding statements.

A graphical user interface (GUI) may be provided for user input, for example of any parameters of selections, and for display of the results of the modification (and potentially of a subsequent simulation). A GUI is commonly provided as a computer software tool executed on a computing device such as a terminal which has at least a screen for display and input means for the user, such as a keyboard and mouse arrangement.

A GUI can allow viewing and/or manual input in the CCMP stage, facilitating adaptation of the perforation routine if necessary.

According to an embodiment of a still further aspect of the invention there is provided a computing apparatus arranged to simplify a geometrical model, wherein the geometrical model includes a pattern of perforations in a perforated component and an edge pattern where the pattern of perforations finishes as one or more incomplete perforations, the computing apparatus comprising: a perforation detector configured to detect the pattern of perforations in the perforated component; an edge feature detector configured to detect one or more edge features of the edge pattern; a comparator configured to compare a perforation from the pattern of perforations with an edge feature; an incomplete perforation detector configured to use the comparison to detect an incomplete perforation of the edge pattern; and a remover configured to remove the detected pattern of perforations and the detected incomplete perforation of the edge pattern from the geometrical model.

The skilled reader will appreciate that the functional items described above (such as a perforation detector, edge feature detector, comparator, incomplete perforation detector and remover) with respect to the computing apparatus may be embodied as one or more suitably programmed processors accessing memory and input/output devices as necessary. The same processor or processors may act as any or all of the functional items. Equally, different processors may be used to make up a single one of the functional items.

A computing apparatus according to preferred embodiments of the present invention can comprise any combination of the previous method aspects in functional features. Methods according to invention embodiments can be described as computer-implemented in that they require processing and memory capability.

The apparatus according to preferred embodiments is described as configured or arranged to carry out certain functions. This configuration or arrangement could be by use of hardware or middleware or any other suitable system. In preferred embodiments, the configuration or arrangement is by software.

The invention can be implemented in digital electronic circuitry, or in computer hardware, firmware, software, or in combinations of them. The invention can be implemented as a computer program or computer program product, i.e., a computer program tangibly embodied in an information carrier, e.g., in a machine-readable storage device or in a propagated signal, for execution by, or to control the operation of, one or more hardware modules. A computer program can be in the form of a stand-alone program, a computer program portion or more than one computer program and can be written in any form of programming language, including compiled or interpreted languages, and it can be deployed in any form, including as a stand-alone program or as a module, component, subroutine, or other unit suitable for use in a data processing environment. A computer program can be deployed to be executed on one module or on multiple modules at one site or distributed across multiple sites and interconnected by a communication network.

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions coupled to one or more memory devices

The invention is described in terms of particular embodiments. Other embodiments are within the scope of the following claims. For example, the steps of the invention can be performed in a different order and still achieve desirable results.

Reference is now made, by way of example only, to the accompanying figures, in which;
Figure 1 shows several pictorial examples of simplification;
Figure 2 shows three examples of edge patterns in porous media;
Figure 3 shows the result of simplification using prior art software;
Figure 4 is a flow chart of a method according to a general invention embodiment;
Figure 5 is a schematic diagram of a computer apparatus according to a general invention embodiment;
Figure 6 is a schematic diagram illustrating components of hardware that can be used with an invention embodiment;
Figure 7 is a view of simplification of two different porous components using an invention embodiment;
Figure 8 illustrates part of a porous medium and comparison of a perforation and an edge feature;
Figure 9 is a flow chart with processing according to an overview of an invention embodiment;
Figure 10 is a flow chart showing detection of edge features;
Figure 11 is a view of a component border demonstrating an alternative method of detecting edge features;
Figure 12 is a flow chart matching an edge feature to a perforation; and
Figure 13 is a flow chart matching an edge feature to a perforation in the case of a curved edge feature.

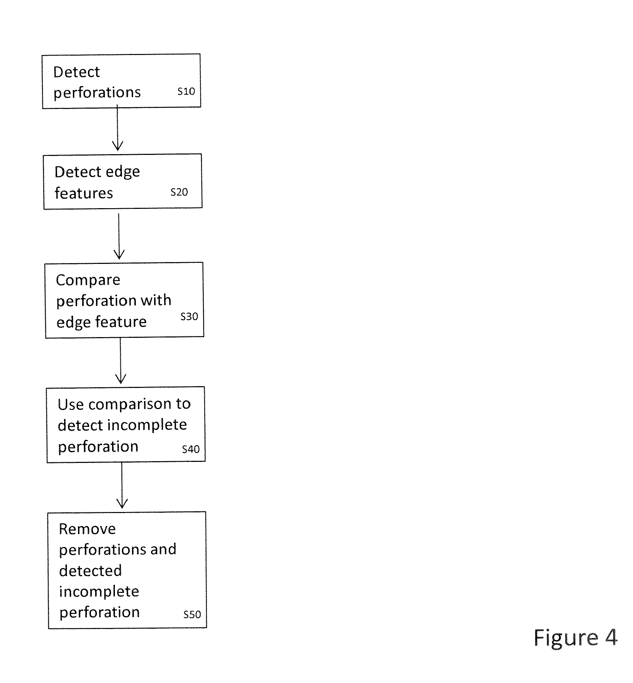

Figure 4 is an overview flow chart of a method according to an invention embodiment. In step S10, perforations (through holes) are detected in a component. In step S20, the method detects edge features of the component border which interrupt a notional straight line edge of the component. In step S30, a detected perforation is compared with an edge feature. This comparison allows detection of an incomplete perforation in step S40 as a shape which matches the perforation. For example, the incomplete perforation or recess in the model border is the same size and shape as a perforation but is open at one side. It may thus, for example, form part of a circle, rather than a complete circle in cross section. In step S50 the detected perforations and detected incomplete perforation(s) are removed to simplify a further potential step of simulation.

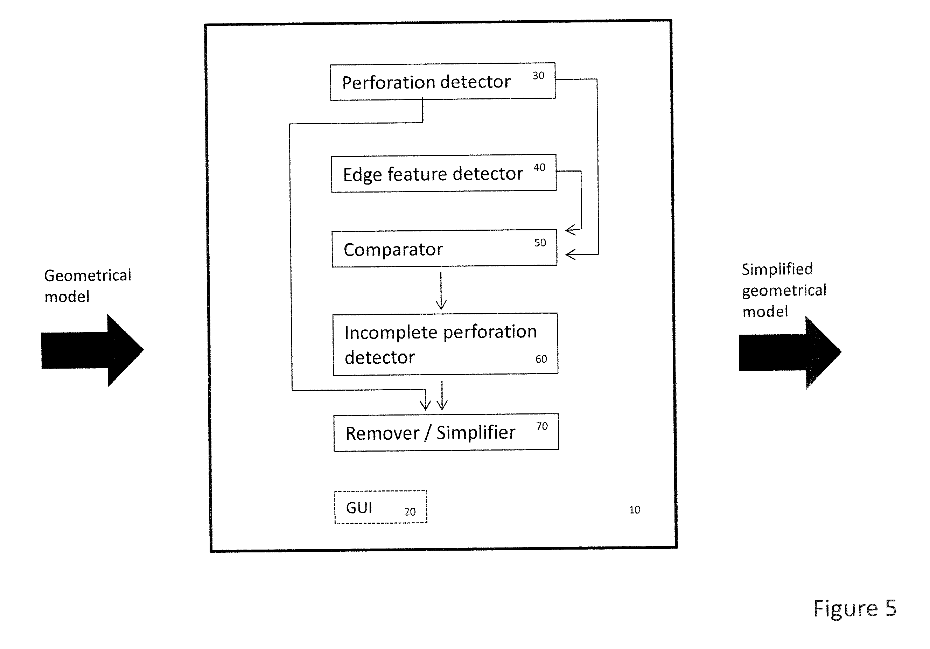

Figure 5 is a top-level illustration of a computing apparatus according to an invention embodiment, which carries out a method of geometrical model simplification. A geometrical model is input into system 10 perhaps using optional GUI 20 and a simplified geometrical model is created and potentially viewed using GUI 20. The computing apparatus includes a perforation detector 30, an edge feature detector 40, a comparator 50, an incomplete perforation detector 60 and a remover/simplifier 70. These functional modules may be created by hardware, software or middleware.

Results from the perforation detector and edge feature detector are fed to the comparator 50 and results of the comparison between an edge feature and a perforation allow detection of an incomplete perforation. All the edge features found may not be incomplete perforations. For example the edge feature might be another type of edge feature, such as a recess shaped differently from the perforations. Comparison with a perforation allows other edge features to be removed from further consideration.

Once the incomplete perforations have been detected, the perforations and the incomplete perforations are removed by remover/simplifier 70, to leave a simplified geometrical model.

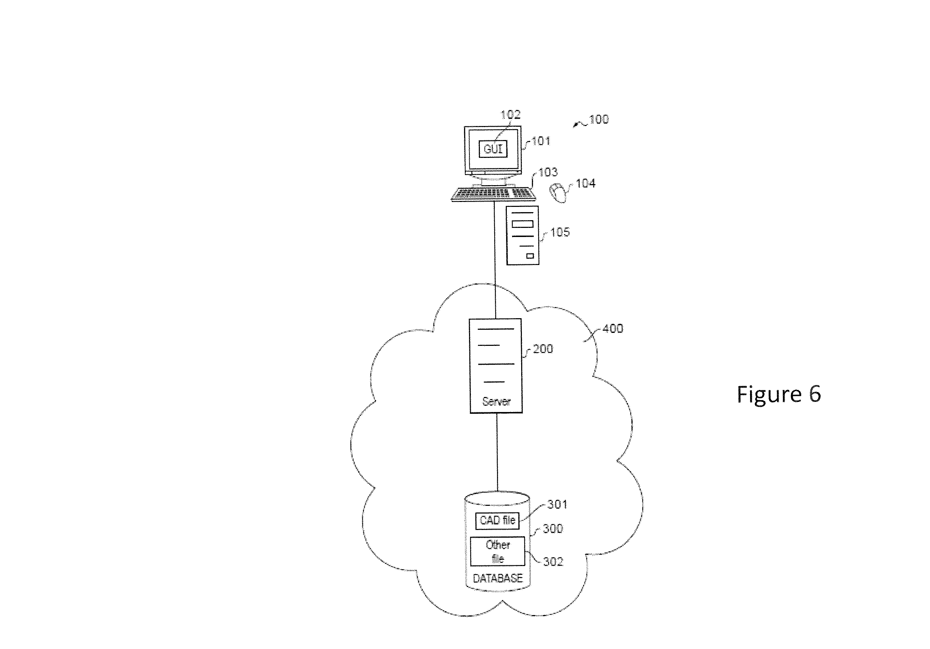

Figure 6 is a schematic diagram illustrating components of hardware that can be used with invention embodiments. In one scenario, the invention embodiments can be brought into effect on a simple stand-alone PC or terminal 100 shown in Figure 6. The terminal comprises a monitor 101, shown displaying a GUI 102, a keyboard 103, a mouse 104 and a tower 105 housing a CPU, RAM, one or more drives for removable media as well as other standard PC components which will be well known to the skilled person. Other hardware arrangements, such as laptops, iPads and tablet PCs in general could alternatively be provided. The software for carrying out the method of invention embodiments as well as a CAD data file and any other file required may be downloaded, for example over a network such as the internet, or using removable media. Any modified CAD file can be written onto removable media or downloaded over a network.

Alternatively, PC 100 may act as a terminal and use one or more servers 200 to assist in carrying out the methods of invention embodiments. In this case, the CAD file 301 and/or software for carrying out the method of invention embodiments may be accessed from database 300 over a network and via server 200. The server 200 and/or database 300 may be provided as part of a cloud 400 of computing functionality accessed over a network to provide this functionality as a service. In this case, PC 100 may act as a dumb terminal for display, and user input and output only. Alternatively, some or all of the necessary software may be downloaded onto the local platform provided by tower 105 from the cloud for at least partial local execution of the method of invention embodiments.

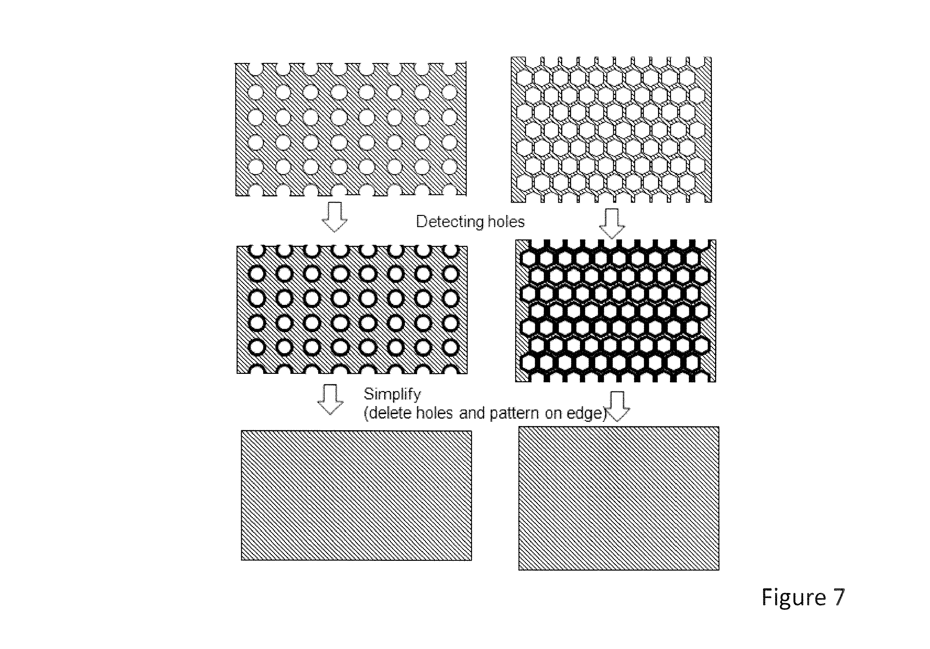

Figure 7 shows the same two porous components as in Figure 3 with detection of holes and edge patterns according to an invention embodiment and with simplification of both the holes and edge patterns. As can be seen from a comparison between Figure 3 and Figure 7, the result is an improved simplification of the two components shown. The simplified components no longer retain the edge patterns formed by incomplete perforations.

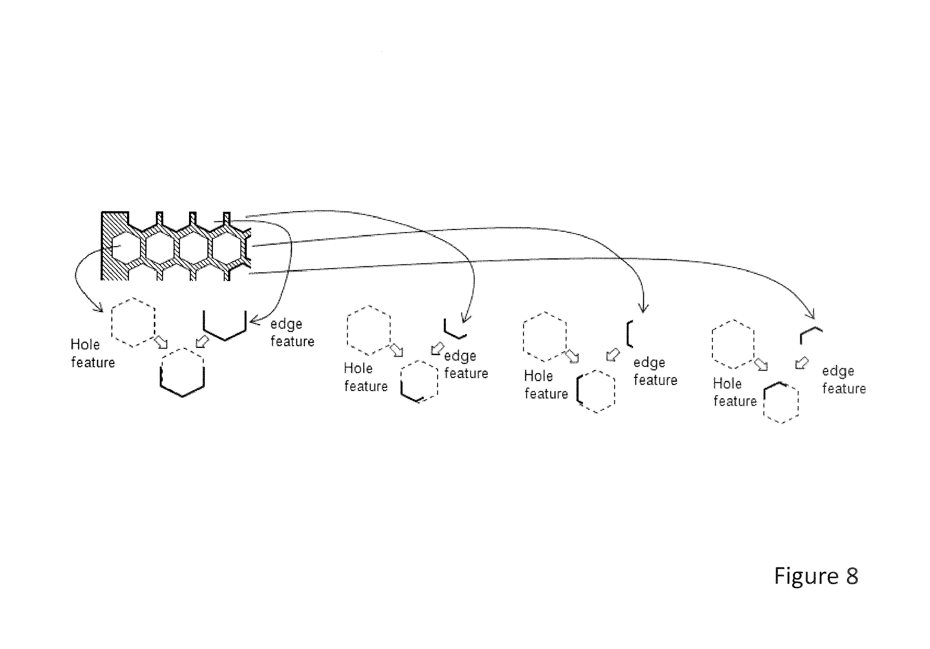

Figure 8 shows how it is possible to detect not only holes, but also edge patterns when a porous medium model is simplified. The edge pattern is essentially part of a hole pattern in the porous medium as shown in Figure 8. By use of this characteristic, edge patterns in the form of incomplete perforations can be detected in the porous medium model. In many cases, the edge pattern is a part of a regularly pattern of perforations, and thus individual incomplete perforations can have the same spacing and size as the perforations in the perforation pattern, except that they are cut across by the component border.

Pattern matching can be applied between a hole and one edge features (in the form of an incomplete perforation). In figure 8, the same perforation (or hole feature) is matched against edges of the edge features. This is indicated by the arrows from the individual edge features of the edge pattern to the matching section, in which the hole feature is shown as a dashed shape and the edge feature is shown as a bold shape. By superimposing the hole feature and edge feature, it can be seen that the edge feature is an incomplete part of the hole feature (or not, as the case may be). This method can be applied not only to rectangular porous media but also to porous media of an arboratory shape.

The benefits of this approach are that the porous media model may be simplified completely and that the edge pattern can be effectively "flattened". Additionally, a more accurate apparture ratio may be derived than by using prior art, in which features corresponding to incomplete perforations were not simplified.

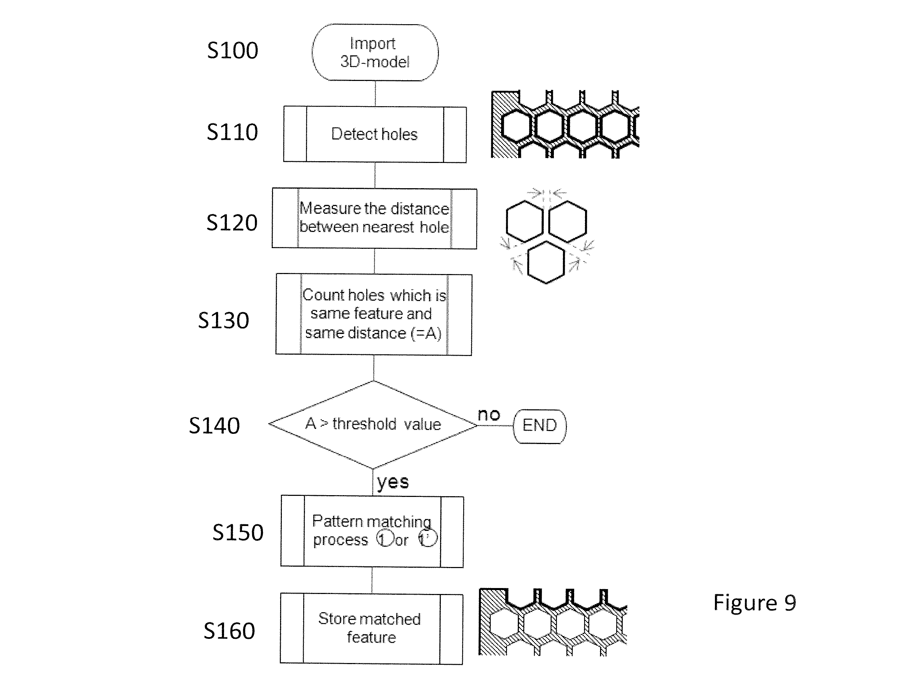

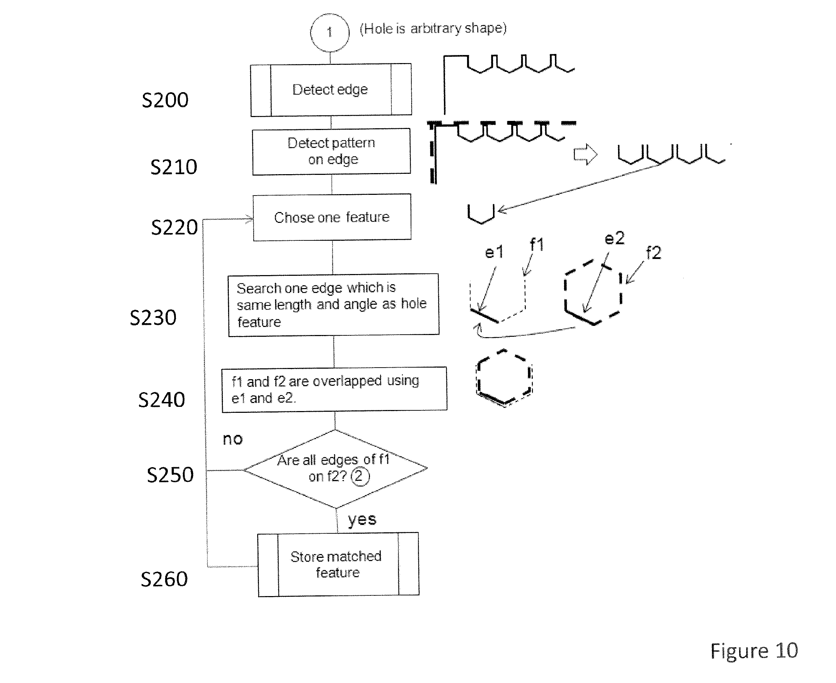

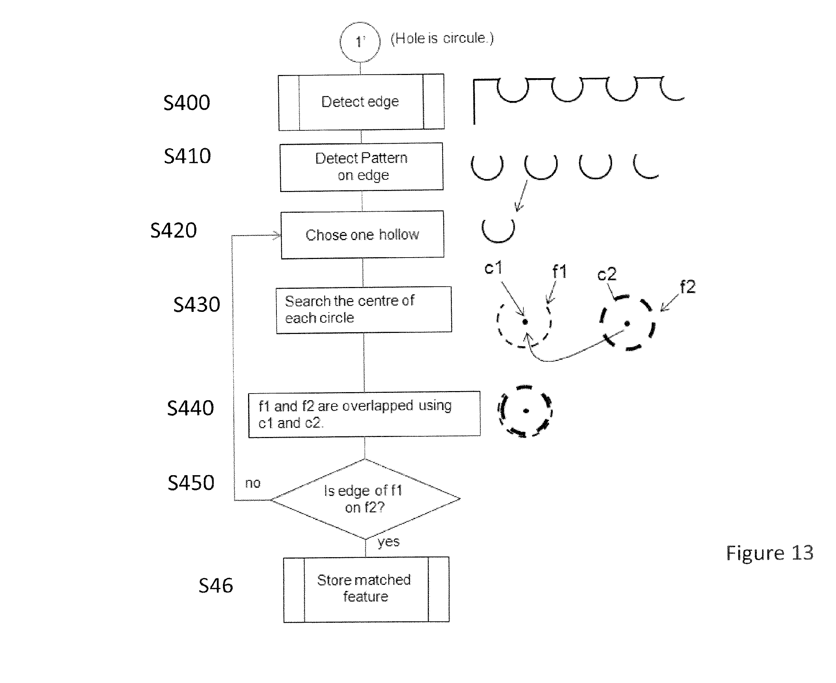

An overall process of this invention is described in figure 9. After the model is imported to the software in step S100, hole features are detected in step S110. The software counts the number of hole features which are congruent (of the same shape and size) with the pitch between these holes of the same length (shown as S120 for the pitch measurement and S130 for the congruence and pitch together) to count congruent holes at a consistent pitch. If the number of such holes, A, is over the threshold value in step S140, the software regards this model as a porous medium model, if not the process ends. After that, the process moves to an edge pattern detecting and matching process in step S150. The pattern matching process differs between an arbitrary shape with more than one side and the case of a single curve edge feature such as a circle. An arbitrary shape includes holes comprised of plural edges each of which can be a straight edge or a curved edge. If the hole is of an arbitrary shape, the process moves to 1 in Figure 10. If the hole is a circle, the process moves to 1' (figure 13).

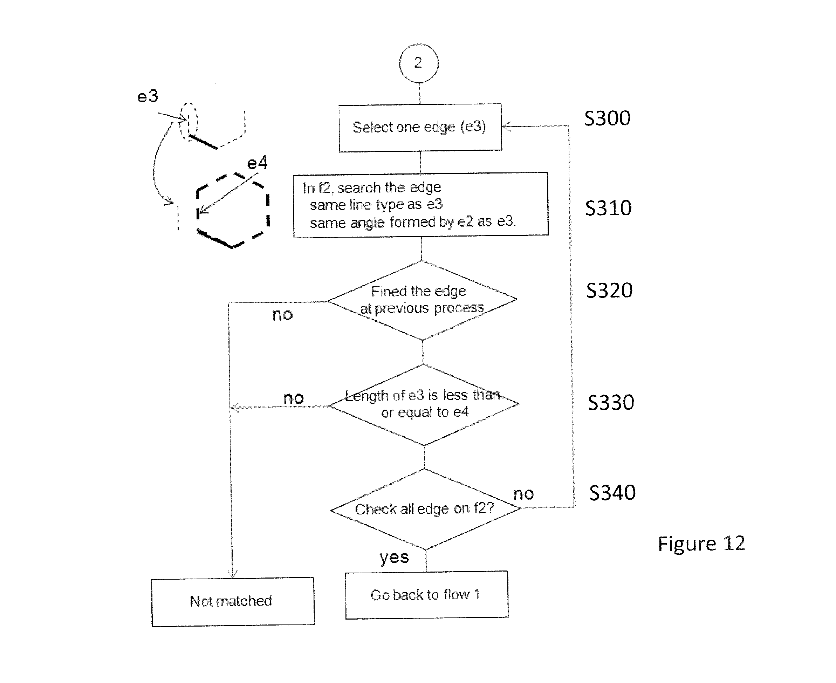

Figure 10 shows a process which may be applied to the case of an arbitrary shape edge feature, with an illustration of the method steps to the right of the flow chart. In step S200, the border (referred to in the diagrams using "edge" in its general sense) of the porous medium model is detected. In step S210, the part of the border which overlaps a boundary box line (shown as a dotted line in the figure) is removed from the border which is detected in the first step. The edge pattern remains. In step S220, one feature of the edge pattern is selected. In step S230, an edge of the edge pattern is found which is identical to an edge of the hole. The dotted line of selected edge feature "f1" shown to the right of this diagram demonstrates the edges selected in step S220. The dotted shape "f2" to the right of "f1" is the hole which is a part of the porous medium. The solid edge "e1" in f1, which is the same length and same angle as the edge "e2" in f2 is detected. In step S240, f1 and f2 are overlapped by use of e1 and e2. In step S250 it is determined whether all edges in f1 are on f2. If so, f1 is a part feature of the hole in the porous medium. The details of the overlapping procedure are described in figure 12.

Finally, if there is a match found in step S250, the edge feature is stored in step S260. If there is no match, the process continues with the next edge feature.

The above methodology relies on a boundary box such as a rectangular boundary box to provide the boundary box line to separate the edge pattern for analysis. This is suitable when the part is rectangular. For more complex shapes, edge features can be detected using angles of individual edges. In this alternative, the assumption is made that the edge pattern is formed on an otherwise straight border of the component.

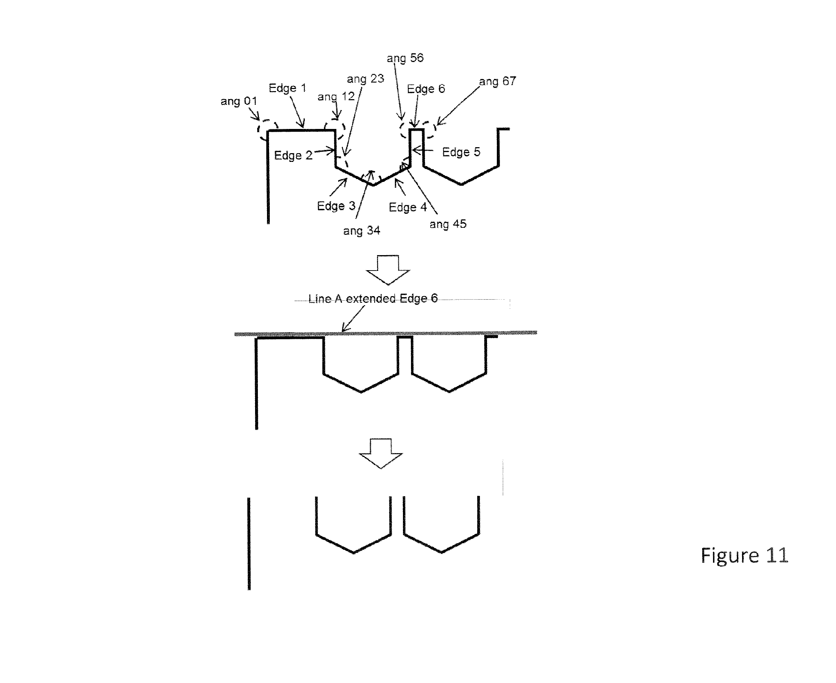

Figure 11 shows a labelled edge pattern in the top section, with Edge 0 to Edge 6 labelled and with angles between the edges labelled ang 01 etc., with the numerals indicating the two edges which the angle links. As a first step in this alternative detection of edge features, the method finds an edge bounded by angles of larger than 180 degrees. For example ang 56 and ang 67 are larger than 180 degrees. Therefore Edge 6 is detected. Edge 6 is then extended and shown as line A in the middle section of figure 11. Finally, in the bottom section of Figure 11, the parts of the outer edge loop or border of the component which overlap with line A have been removed. This separates the edge features from the otherwise straight border.

Figure 12 show a detailed procedure for checking whether all the edges of f1 (the edge feature, separated out by one of the above methods or by another method) overlap with f2 (the hole). This takes place once the hole an edge feature have been overlapped based on first edges e1 and e2. The process starts from point 2, shown in step S250 of Figure 10. In step S300, one edge is selected from edge feature f1. The selected edge is called "e3" as shown to the left of the flow diagram.

In step S310, the method searches for an edge of hole f2 which is same line type as e3 and same angle to the first edge e2 as e3. The line types can include straight, ellipse, spline etc, and may be defined in the general CAD kernel. If such an edge of the hole is found, it is called "e4", as shown in the figure. In step S320, if e4 is NOT found, f1 cannot match f2. In step S330, if the length of e3 is NOT less than or equal to e4, f1 cannot match f2. In step S340 if all the edges of f1 have been checked, the process goes back to 1 in figure 9 to store the matched feature. If not, this process is applied to the next edge of f1.

Figure 13 shows the process which is applied in the case that the hole is a circle, or another continuous curve shape. Steps S400 to S420 are equivalent to those of Figure 10, steps S200 to S220. In the explanatory figure to the right of the flowchart against step S430, the dotted line "f1" is the edge feature which is selected in step S420. The dotted line "f2" further to the right is the edge of the hole which is a part of the porous medium. The centers of each circle are detected in step S430. The center of f1 is called "c1 "and that of f2 is called "c2". In step S440, f1 and f2 are overlapped by use of c1 and c2. In step S450 it is detected whether the edge of f1 is on f2. If so, f1 is a part feature of the hole in the porous medium and is stored in step S460.

### Some Benefits of Invention Embodiments

Invention embodiments allow simplification of the porous medium model which has patterned edge, as shown in figure 7. Therefore, the mesh scale for simulation in, for example, CFD can be reduced. The mesh number may be in the terms of thousands when mesh is generated in a porous medium model. However, that can reduce to hundreds after the simplification to a rectangular shape. Furthermore, accuracy of aperture ratio which is derived from a CAD model is better than that when the edge pattern is not considered.

## Claims

1. A method of simplifying a geometrical model, wherein the geometrical model includes a pattern of perforations in a perforated component and an edge pattern where the pattern of perforations finishes at a component border as one or more incomplete perforations, the method comprising:
detecting the pattern of perforations in the perforated component;
detecting one or more edge features of the edge pattern;
comparing a perforation from the pattern of perforations with an edge feature;
using the comparison to detect an incomplete perforation of the edge pattern; and
removing the detected pattern of perforations and the detected incomplete perforation of the edge pattern from the geometrical model.

2. A method according to claim 1, wherein the one or more edge features are detected by finding any outside edge which does not coincide with a rectangular boundary box fitted to the border of the perforated component and, for the purposes of the comparison, removing the border where it coincides with the boundary box to leave a remaining pattern of one or more edge features.

3. A method according to claim 1, wherein the one or more edge features are detected by finding an outside edge which is bounded by two vertices having outside angles of more than 180°, extending the edge to form a boundary line along the perforated part and, for the purposes of the comparison, removing any border sections which overlap with the boundary line, leaving a remaining pattern of one or more edge features.

4. A method according to claim 3, wherein an edge feature of the remaining pattern is selected for comparison if there is more than one edge feature and the comparison to detect an incomplete perforation is carried out individually for each edge feature.

5. A method according to any of the preceding claims, wherein it is determined whether the edge feature comprises either plural edges or a single curved edge.

6. A method according to any of the preceding claims, wherein the comparison includes a geometrical comparison of the edge feature with the perforation, by comparing the one or more edges making up the edge feature against the one or more edges of the perforation, wherein an incomplete perforation is detected if there is a match between the compared edges.

7. A method according to claim 5 or 6, wherein the edge feature is formed of plural edges and the method finds one edge of the edge feature which is the same length, line type and angle as one edge of the perforation, and overlaps the perforation and the edge feature based on this edge.

8. A method according to claim 7, wherein each further edge of the edge feature is matched against an edge of the perforation and if no match is found for any one of the edges, the matching process is terminated without finding an incomplete perforation, whereas an incomplete perforation is detected if all the edges of the edge feature then overlap with the perforation.

9. A method according to claim 7 or 8, wherein the further edges are each matched by finding an edge of the perforation which has the same line type and angle and a length at least as long as the length of the further edge.

10. A method according to claim 5 or 6, wherein the edge feature is formed of a single edge feature curve, wherein the method finds the central point around which the edge feature curve extends and the central point of the perforation and overlaps these points.

11. A method according to claim 10, wherein an incomplete perforation is detected if all of the curved edge of the edge feature then overlaps with the curved edge of the perforation.

12. A method according to any of the preceding claims, wherein detecting the pattern of perforations includes detecting holes in a component, detecting distances between adjacent holes, and counting the number of identical holes which are spaced apart by an identical distance, wherein a threshold is applied to the count, above which the detected holes are defined as a pattern of perforations and the component is defined as a perforated component.

13. A method according to any of the preceding claims, wherein the detected pattern of perforations and the detected incomplete perforations on the patterned edge are replaced with a solid portion of the component, preferably having a porosity value corresponding to the porosity effect of the perforations and the incomplete perforations and more preferably based on the ratio between the cross-sectional area of the pattern of perforations and incomplete perforations, and an area of a surface of the perforated component through which they pass.

14. A computer program which when executed on a computing apparatus carries out the method of any of the preceding claims.

15. A computing apparatus arranged to simplify a geometrical model, wherein the geometrical model includes a pattern of perforations in a perforated component and a edge pattern where the pattern of perforations finishes as one or more incomplete perforations, the computing apparatus comprising:
a perforation detector configured to detect the pattern of perforations in the perforated component;
an edge feature detector configured to detect one or more edge features of the edge pattern;
a comparator configured to compare a perforation from the pattern of perforations with an edge feature;
an incomplete perforation detector configured to use the comparison to detect an incomplete perforation of the edge pattern; and
a remover configured to remove the detected pattern of perforations and the detected incomplete perforation of the edge pattern from the geometrical model.

## Amended claims

### Amended claims in accordance with Rule 137(2) EPC.

1. A computer-implemented method of simplifying a geometrical model, wherein the geometrical model includes a pattern of perforations in a perforated component, the pattern of perforations finishing at a component border as one or more incomplete perforations forming an edge pattern, the method comprising:
detecting a pattern of perforations as through holes in a perforated component;
detecting one or more edge features of the perforated component;
comparing a perforation from the pattern of perforations with the edge feature;
using the comparison to detect that the edge feature has a shape that matches the perforation and is thus an incomplete perforation forming an edge pattern of the pattern of perforations; and
removing the detected pattern of perforations including the detected incomplete perforation of the edge pattern from the geometrical model by replacing it with a solid portion to simplify the geometrical model for thermal airflow analysis.

2. A method according to claim 1, wherein the one or more edge features are detected by finding any outside edge which does not coincide with a rectangular boundary box fitted to the border of the perforated component and, for the purposes of the comparison, removing the border where it coincides with the boundary box to leave a remaining pattern of one or more edge features.

3. A method according to claim 1, wherein the one or more edge features are detected by finding an outside edge which is bounded by two vertices having outside angles of more than 180°, extending the edge to form a boundary line along the perforated part and, for the purposes of the comparison, removing any border sections which overlap with the boundary line, leaving a remaining pattern of one or more edge features.

4. A method according to claim 3, wherein an edge feature of the remaining pattern is selected for comparison if there is more than one edge feature and the comparison to detect an incomplete perforation is carried out individually for each edge feature.

5. A method according to any of the preceding claims, wherein it is determined before the comparison whether the edge feature comprises either plural edges or a single curved edge, to choose the comparison procedure.

6. A method according to any of the preceding claims, wherein the comparison includes a geometrical comparison of the edge feature with the perforation, by comparing the one or more edges making up the edge feature against the one or more edges of the perforation, wherein an incomplete perforation is detected if there is a match between the compared edges.

7. A method according to claim 5 or 6, wherein the edge feature is formed of plural edges and the method finds one edge of the edge feature which is the same length, line type and angle as one edge of the perforation, and overlaps the perforation and the edge feature based on this edge.

8. A method according to claim 7, wherein each further edge of the edge feature is matched against an edge of the perforation and if for any one of the edges, no match is found, the matching process is terminated without finding an incomplete perforation, whereas an incomplete perforation is detected if all the edges of the edge feature then overlap with the perforation.

9. A method according to claim 7 or 8, wherein the further edges are each matched by finding an edge of the perforation which has the same line type and angle and a length at least as long as the length of the further edge.

10. A method according to claim 5 or 6, wherein the edge feature is formed of a single edge feature curve with an incomplete circular cross section, wherein during the comparison the method finds the central point around which the edge feature curve extends and the central point of the perforation and superimposes these points.

11. A method according to claim 10, wherein an incomplete perforation is detected if all of the curved edge of the edge feature then overlaps with the curved edge of the perforation.

12. A method according to any of the preceding claims, wherein detecting the pattern of perforations includes detecting holes in a component, detecting distances between adjacent holes, and counting the number of identical holes which are spaced apart by an identical distance, wherein a threshold is applied to the count, above which the detected holes are defined as a pattern of perforations and the component is defined as a perforated component.

13. A method according to any of the preceding claims, wherein the detected pattern of perforations and the detected incomplete perforations on the patterned edge are replaced with a solid portion of the component having a porosity value corresponding to the porosity effect of the perforations and the incomplete perforations and more preferably based on the ratio between the cross-sectional area of the pattern of perforations and incomplete perforations, and an area of a surface of the perforated component through which they pass.

14. A computer program which when executed on a computing apparatus carries out the method of any of the preceding claims.

15. A computing apparatus arranged to simplify a geometrical model, wherein the geometrical model includes a pattern of perforations in a perforated component, the pattern of perforations finishing as one or more incomplete perforations forming an edge pattern, the computing apparatus comprising:
a perforation detector configured to detect a pattern of perforations as through holes in a perforated component;
an edge feature detector configured to detect one or more edge features of the perforated component;
a comparator configured to compare a perforation from the pattern of perforations with the edge feature;
an incomplete perforation detector configured to use the comparison to detect that the edge feature is an incomplete perforation forming an edge pattern of the pattern of perforations; and
a remover configured to remove the detected pattern of perforations including the detected incomplete perforation of the edge pattern from the geometrical model by replacing it with a solid portion to simplify the geometrical model for thermal airflow analysis.
